# FASCICULE DE BREVET EUROPEEN

(11) **EP 0 366 546 B1**
(45) Date de publication et mention de la délivrance du brevet: **16.06.1993**
(21) Numéro de dépôt: 89402945.3
(22) Date de dépôt: 25.10.1989
(51) Int. Cl.: H05K 5/00

(54) **Socle pour appareillage électrique, notamment centrale d'alarme, et appareillage électrique correspondant**
Sockel für Elektrogeräte, insbesondere Alarmzentrale und entsprechende Elektrogeräte
Socket for an electrical device, especially an alarm post, and the electrical device

(30) Priorité: 27.10.1988 FR 8814047
(43) Date de publication de la demande: 02.05.1990
(73) Titulaire: LEGRAND, F-87045 Limoges Cédex (FR)
(72) Inventeur: Parlatore, Roger, F-87920 Condat (FR); Hennequin, Guy, F-87590 St Just Le Martel (FR); Goudal, Jean-Paul, F-87000 Limoges (FR)
(74) Mandataire: CABINET BONNET-THIRION

(56) Documents cités:
- WO-A-82/01953
- FR-A- 1 348 392
- GB-A- 2 126 016

## Description

La présente invention concerne d'une manière générale les appareillages électriques du genre comportant, rapportés sur un socle lui-même à fixer sur un quelconque support, une pluralité de composants, éventuellement regroupés en blocs fonctionnels, avec, le plus souvent, recouvrant le tout, un couvercle.

Un tel appareillage électrique est connu par le document GB-A-2 126 016.

Dans ce document, tous les câbles cheminent dans le même espace avant leur connexion.

L'invention vise plus particulièrement le cas où, pour la desserte d'un appareillage électrique, interviennent des courants de deux natures différentes, à savoir, par exemple, d'une part, des courants forts de basse tension alternative, de l'ordre par exemple de 250 volts, en pratique le secteur, et, d'autre part, des courants faibles de très basse tension, alternative ou continue, de l'ordre par exemple de 12 volts.

C'est le cas, notamment, des centrales d'alarme, qu'il s'agisse de centrales d'alarme anti-intrusion, de centrales d'alarme incendie, ou de centrales d'alarme regroupant l'une et l'autre des deux protections correspondantes.

Ces centrales d'alarme comportent, en effet, d'une part, un circuit d'alimentation, auquel il convient de câbler des conducteurs propres à leur alimentation en courant fort, et, d'autre part, des circuits de détection, auxquels il convient au contraire de câbler des conducteurs qui, porteurs de courant faible, sont destinés à permettre leur raccordement à divers organes de détection, de commande, ou d'arlarme, disséminés aux alentours.

Selon les règles de normalisation s'appliquant à de tels appareillages électriques, il importe d'assurer une séparation diélectrique convenable entre ce circuit d'alimentation, en courant fort basse tension, et ces circuits de détection, en courant faible très basse tension.

La présente invention a d'une manière générale pour objet une disposition permettant de satisfaire à cette exigence et conduisant en outre à d'autres avantages.

De manière plus précise, elle a tout d'abord pour objet un socle pour appareillage électrique, notamment centrale d'alarme, du genre comportant une semelle propre à son application contre un quelconque support et à sa fixation à celui-ci, ce socle étant caractérisé en ce que, à l'intérieur de son pourtour, ladite semelle s'étend suivant au moins deux niveaux différents, en sorte que, sur sa face arrière, elle forme un dégagement destiné au cheminement de conducteurs porteurs de courant d'une première nature, en ce que, sur sa face avant, elle porte, en retrait par rapport à son pourtour, sur une partie au moins de la longueur de ce pourtour, des éléments de paroi, qui, en saillie sur cette face avant, y délimitent au moins pour partie, au moins un compartiment destiné au logement de composants fonctionnels, avec au moins un passage par lequel ledit dégagement communique avec un tel compartiment, et en ce qu'elle présente, sur l'un au moins de ses côtés, entre lesdits éléments de paroi et son pourtour, au moins un ajour par lequel ledit dégagement communique par ailleurs avec un volume périphérique qui, extérieur audit compartiment, est destiné au cheminement de conducteurs porteurs de courant d'une deuxième nature ; elle a encore pour objet un appareillage électrique, en particulier une centrale d'alarme, du genre comportant, rapportés sur un socle, une pluralité de blocs fonctionnels, et caractérisé en ce que ce socle est conforme au précédent.

En pratique, le dégagement présent sur la face arrière de la semelle du socle suivant l'invention est destiné au cheminement des conducteurs porteurs de courant fort, tandis que le volume periphérique présent sur sa face avant est destiné au cheminement des conducteurs porteurs de courant faible.

La séparation diélectrique recherchée entre ces divers conducteurs se touve ainsi tout naturellement et efficacement assurée.

Suivant un premier développement de l'invention, elle se trouve renforcée par le fait que, dans le dégagement que forme la semelle sur sa face arrière, est disposé, pour le cheminement des conducteurs porteurs de courant fort, un tube souple, qui s'étend à compter du passage faisant communiquer ce dégagement avec un compartiment présent sur la face avant de la semelle, et qui traverse celle-ci à la faveur d'un de ses ajours.

Suivant un autre développement de l'invention, elle se trouve encore renforcée par le fait que, le passage en question débouchant dans un logement qui est en creux par rapport au compartiment concerné, l'un des blocs fonctionnels, qui est amovible, de l'appareillage électrique correspondant, recouvre, d'une part ce logement, et, d'autre part, une borne de connexion, qui, disposée en bordure de celui-ci, est prévue pour le raccordement des conducteurs porteurs de courant fort.

Outre que le logement en question permet avantageusement d'avaler le mou de ces conducteurs après leur raccordement à la borne de connexion prévue pour eux, ils sont, ainsi, en service, totalement recouverts par un bloc fonctionnel, y compris leur extrémité de raccordement à cette borne de connexion, ce qui les isole encore plus sûrement du reste de l'ensemble.

Dans tous les cas, la semelle du socle suivant l'invention présentant un ajour sur chacun de ses côtés, les divers conducteurs concernés, qu il s'agisse des conducteurs porteurs de courant fort ou qu'il s'agisse des conducteurs porteurs de courant faible, peuvent, avantageusement, arriver, indifféremment, à la faveur d'un tel ajour, sur l'un quelconque de ces côtés, ce qui rend particulièrement aisé le câblage de l'appareillage électrique correspondant.

S'agissant des conducteurs porteurs de courant faible, ce câblage se trouve encore facilité, suivant un développement de l'invention, par le fait que, dans l'appareillage électrique concerné, les borniers correspondants sont disposés en bordure du volume périphérique présent sur la face avant de la semelle du socle suivant l'invention, et que, grâce à ce volume périphérique, qui forme en quelque sorte, autour de l'ensemble, un couloir donnant accès à ces borniers, ils peuvent cheminer vers ceux-ci quel que soit le côté de ce socle par lequel ils arrivent.

Enfin, la présence de compartiments sur la face avant du socle suivant l'invention favorise une disposition complémentaire suivant laquelle les composants ne présentant aucun risque de panne sont rapportés sur une carte de base fixée à demeure sur ce socle tandis que ceux présentant des risques de panne sont répartis en blocs fonctionnels rapportés de manière amovible sur cette carte de base.

En cas de panne, il suffit, après un diagnostic simple, de procéder au remplacement du bloc fonctionnel défaillant.

En bref, le socle suivant l'invention permet d'assurer une séparation diélectrique efficace, entre les courants de natures différentes arrivant à l'appareillage électrique concerné, il rend aisé le câblage de cet appareillage électrique, et il en facilite la maintenance.

Les caractéristiques et avantages de l'invention ressortiront d'ailleurs de la description qui va suivre, à titre d'exemple, en référence aux dessins schématiques annexés sur lesquels :
la figure 1 est, avec des arrachements locaux, une vue en perspective d'un appareillage électrique suivant l'invention ;
la figure 2 est, à échelle supérieure, une vue en perspective du seul socle de cet appareillage électrique, vu de l'avant ;
la figure 3 est, à l'échelle de la figure 2, une autre vue en perspective, vu de l'arrière, de ce socle ;
la figure 4 en est, à échelle supérieure, une vue en plan, suivant la flèche IV de la figure 2 ;
les figures 5, 6 en sont des vues en coupe, suivant, chacune respectivement, les lignes brisées V-V et VI-VI de la figure 4 ;
la figure 7 en est, à échelle différente, une vue partielle en coupe, suivant la ligne VII-VII de la figure 4 ;
la figure 8 est, à l'échelle de la figure 7, une vue en plan d'un cavalier associé au socle suivant l'invention ;
la figure 9 est une vue en plan qui, reprenant pour partie la figure 4, suivant l'encart IX de celle-ci, illustre une partie du câblage de l'appareillage électrique concerné.

Ces figures illustrent, à titre d'exemple, l'application de l'invention à une centrale d'alarme.

De manière connue en soi, cette centrale d'alarme comporte, globalement, un socle 10, par lequel elle est destinée à être rapportée sur un quelconque support, par exemple un mur, et, eux-mêmes rapportés sur ce socle 10, suivant des dispositions succinctement décrites ci-après, une pluralité de composants fonctionnels, avec, recouvrant le tout, en étant solidarisable de manière amovible au socle 10 par des vis 11, un couvercle 12.

Les composants fonctionnels mis en oeuvre ne relevant pas de la présente invention, ils ne seront pas décrits en détail ici.

Il suffira d'indiquer que ceux de ces composants fonctionnels qui ne sont pas susceptibles de panne sont de préférence regroupés sur une carte de base 13, destinés à être rapportée à demeure sur le socle 10, et que ceux qui sont au contraire susceptibles de pannes sont regroupés en blocs fonctionnels, qui, ici au nombre de deux, à savoir un bloc d'alimentation 14A et un bloc de gestion 14B, sont adaptés à être rapportés, de manière amovible, sur la carte de base 13.

A ces deux blocs fonctionnels 14A, 14B est adjointe, dans la forme de réalisation représentée, pour une éventuelle auto-alimentation de l'ensemble, une batterie 14C destinée à être directement rapportée sur le socle 10, à l'écart de la carte de base 13.

Pour donner accès au bloc de gestion 14B, le couvercle 12 comporte une fenêtre 16 éventuellement fermée par un volet de protection.

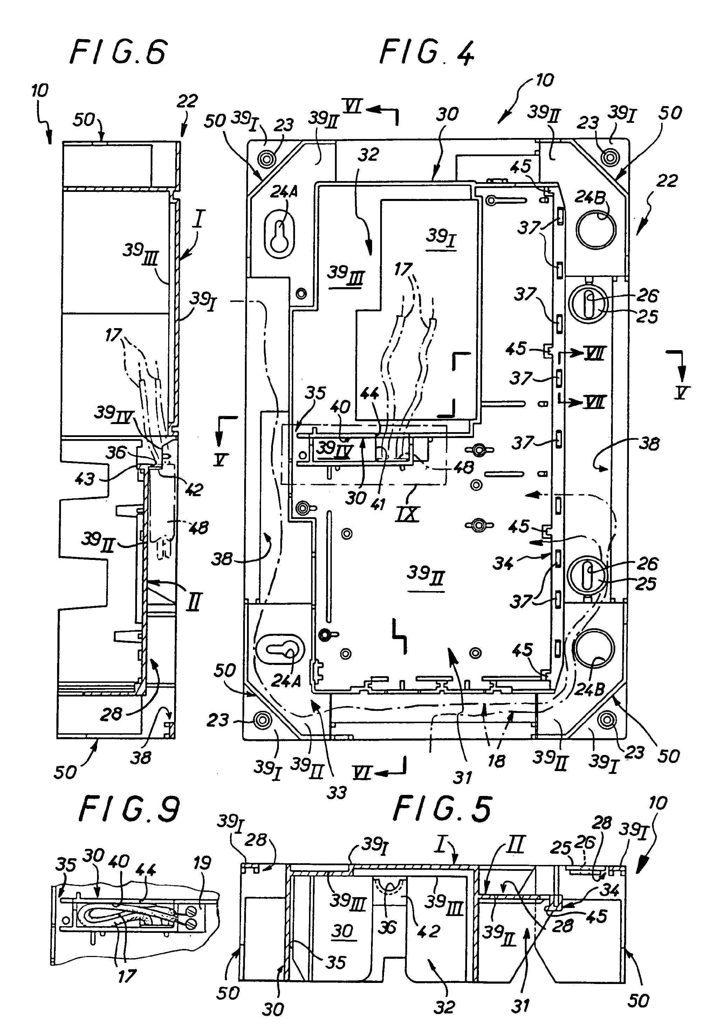

La desserte de la centrale d'alarme ainsi constituée nécessite, d'une part, pour son alimentation, des conducteurs électriques 17, propres à son raccordement à une quelconque source d'alimentation en courant fort, par exemple le secteur, et, d'autre part, pour sa liaison à des organes de détection extérieurs, et tel que schématisé en traits interrompus pour deux d'entre eux à la figure 4, des conducteurs électriques 18 porteurs, eux, de courant faible.

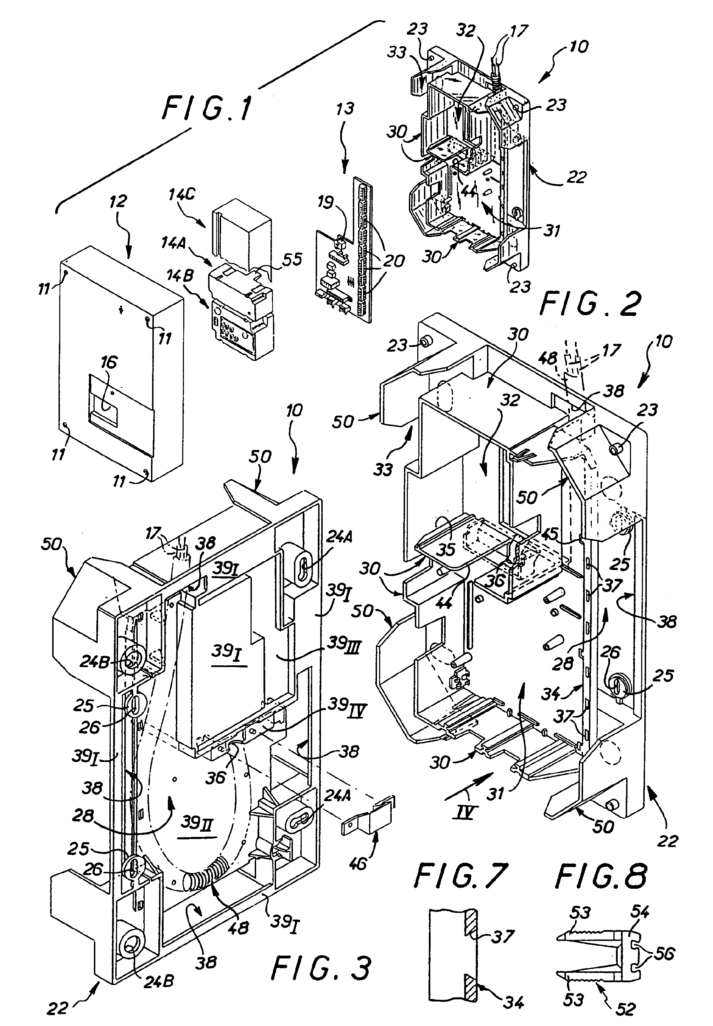

Le raccordement des conducteurs électriques 17 se fait par une borne de connexion 19, figures 1 et 7, portée par la carte de base 13, et, de même, le raccordement des conducteurs électriques 18 se fait par des borniers 20, figure 1, eux aussi portés par celle-ci.

De manière connue en soi, le socle 10, qui fait l'objet de la présente invention, comporte une semelle 22 propre à son application contre le support à équiper et à sa fixation à celui-ci.

Dans la forme de réalisation représentée, cette semelle 22 a un contour rectangulaire.

Dans ses zones d'angle elle présente des puits 23 propres à coopérer avec les vis 11 nécessaires à la fixation du couvercle 12.

Elle y présente, également, décalés longitudinalement par rapport à ces puits 23, des perçages 24A, 24B propres au passage des moyens de fixation nécessaires à son assujettissement au support à équiper.

Les perçages 24A, qui sont au nombre de deux, en étant disposés le long d'un même bord longitudinal, sont ici des boutonnières en trou de serrure, l'une allongée dans un sens, l'autre allongée dans le sens perpendiculaire au précédent.

Suivant des modalités qui, ne relevant pas de la présente invention, ne seront pas décrites en détail ici, les perçages 24B, qui sont également au nombre de deux, en étant disposés le long du bord longitudinal opposé au précédent, sont ici constitués de simples trous de contour circulaire, et il leur est associé des rondelles 25, qui, moulées d'un seul tenant avec l'ensemble, sont propres à être montées, une fois détachées d'un tel ensemble, dans ces perçages 24B, suivant une orientation angulaire quelconque par rapport à l'axe de ceux-ci, et qui présentent chacune une simple boutonnière 26.

La semelle 22 du socle 10 suivant l'invention s'étend, à l'intérieur de son pourtour, suivant au moins deux niveaux I, II différents, en sorte que, sur sa face arrière, celle par laquelle elle est destinée à être appliquée au support à équiper, elle forme un dégagement 28.

Dans la forme de réalisation représentée, ce dégagement 28 a, globalement, en plan, un contour en L, parallèlement aux bords de la semelle 22, et avec une barre de ce contour nettement plus large que l'autre.

Conjointement, la semelle 22 du socle 10 suivant l'invention porte, sur sa face avant, en retrait par rapport à son pourtour, des éléments de paroi 30, qui, en saillie sur cette face avant, y délimitent, au moins pour partie, et suivant des modalités décrites plus en détail ultérieurement, au moins un compartiment 31, 32, avec, extérieur à un tel compartiment 31, 32, entre lesdits éléments de paroi 30 et son pourtour, un volume périphérique 33.

Dans la forme de réalisation représentée, les éléments de paroi 30, qu'il n'est pas nécessaire de décrire en détail ici, ont tous, globalement, même hauteur, et ils délimitent, sur la face avant de la semelle 22, deux compartiments 31, 32.

Le premier, le compartiment 31, est destiné au logement de la carte de base 13, et, avec celle-ci, à celui des blocs fonctionnels 14A, 14B.

Il s'étend globalement à l'aplomb du dégagement 28, et, comme celui-ci, il a, en plan, un contour en L, la carte de base 13 ayant elle-même un tel contour en L.

Le deuxième compartiment, le compartiment 32, est destiné, lui, au logement de la batterie 14C.

En plan, il a, globalement, un contour rectangulaire, et ce contour s'imbrique dans celui du compartiment 31, l'ensemble reprenant, à distance, le contour de la semelle 22.

Alors que les éléments de paroi 30 cernent sur la quasi totalité de son pourtour le compartiment 32, le compartiment 31 est au moins en partie ouvert sur l'un au moins de ses côtés, en bordure du volume périphérique 33 extérieur à l'ensemble.

Dans la forme de réalisation représentée, et pour des raisons qui apparaîtront ultérieurement, ce compartiment 31 est ainsi ouvert sur la totalité d'un de ses côtés, celui correspondant à la plus grande barre de son contour en L, parallèlement à un bord longitudinal de la semelle 22, et il est bordé, le long de ce côté, par une réglette 34, présentant, de place en place, des ajours allongés 37, à raison d'un par bornier 20.

Dans la forme de réalisation représentée, les bords transversaux de ces ajours 37 sont légèrement obliques, en convergeant l'un vers l'autre, figure 7.

La réglette 34 présente en outre, de place en place, en direction du compartiment 31, des saillies 45 sous lesquelles doit être glissée la carte de base 13.

Les compartiments 31, 32 communiquent entre eux.

Pour ce faire, dans la forme de réalisation représentée, des éléments de paroi 30 qui, formant frontière entre ces compartiments 31, 32, s'étendent en refend par rapport à des éléments de paroi 30 formant conjointement un bord longitudinal pour ceux-ci, ménagent, entre eux et ces derniers, une fente 35.

Il est prévu un passage 36 par lequel le dégagement 28 présent sur la face arrière de la semelle 22 communique avec un compartiment 31, 32 présent sur sa face avant, et, plus précisément, avec le volume central intérieur à ce compartiment 31, 32, et, conjointement, cette semelle 22 présente, sur l'un au moins de ses côtés, entre les éléments de paroi 30 et son pourtour, au moins un ajour 38 par lequel ledit dégagement 28 communique par ailleurs avec le volume périphérique 33 extérieur à ce compartiment 31, 32.

En pratique, dans la forme de réalisation représentée, la semelle 22 présente un ajour 38 sur chacun de ces côtés, et un tel ajour 38 est bordé, pour partie, par une portion 39_{I}, de premier niveau I de cette semelle 22, et, pour partie, par une portion 39_{II}, de deuxième niveau II, de celle-ci, en sorte que c'est à la faveur du décalage entre ces portions 39_{I}, 39_{II}, de niveaux I, II différents que cet ajour 38 fait communiquer le dégagement 28 présent sur la face arrière de la semelle 22 avec le volume périphérique 33 présent sur sa face avant.

Dans la forme de réalisation représentée, la semelle 22 ne s'étend, principalement, que suivant deux niveaux, à savoir, d'une part, le premier niveau I, qui correspond à celui de sa face arrière, et auquel appartiennent les diverses portions 39_{I} qu'elle comporte, et, d'autre part, le deuxième niveau II, qui, en retrait par rapport au précédent, est également en retrait par rapport à son pourtour, et auquel appartiennent ses portions 39_{II}.

Cependant, dans la forme de réalisation représentée, à l'intérieur au moins de l'un des compartiments 31, 32 délimités par les éléments de paroi 30, et sur une partie au moins de ce compartiment 31, 32, la semelle 22 s'étend suivant un autre niveau intermédiaire entre les deux premiers niveaux I, II.

C'est le cas, en particulier, pour le compartiment 32, dont le fond est formé pour partie d'une portion 39_{I} de premier niveau I de la semelle 22, et, pour partie, d'une portion 39_{III} de niveau III de cette semelle 22 légèrement en retrait par rapport à la précédente.

Mais c'est le cas, également, pour le compartiment 31.

En effet, dans celui-ci, est présent, en creux, le long des éléments de paroi 30 le séparant du compartiment 32, un logement 40, dont le fond, évidé par un ajour 41 au droit du passage 36, est formé par une portion 39_{IV} de niveau IV de la semelle 22 en retrait par rapport à sa portion 39_{III} de niveau III, entre celle-ci et ses portions 39_{II} de niveau II.

Pour le reste, le fond du compartiment 31 est formé par une portion 39_{II} de niveau II de la semelle 22.

Par l'ajour 41 du fond du logement 40, le passage 36 débouche dans ce logement 40, et, par celui-ci, dans le compartiment 31, celui ouvert sur un côté.

Dans la forme de réalisation représentée, ce passage 36 est formé à la faveur d'une paroi de raccordement 42 intermédiaire entre deux portions de niveaux différents de la semelle 22, en l'espèce une portion 39_{II} de niveau II et une portion 39_{IV} de niveau IV.

Cette paroi de raccordement 42 s'étend sensiblement perpendiculairement aux portions 39_{III}, 39_{IV} de niveaux différents III, IV qu'elle relie, parallèlement aux bords transversaux de la semelle 22.

Dans son prolongement, le logement 40, qui, de l'autre côté, est bordé par les éléments de paroi 30 séparant les compartiments 31, 32, est bordé par un rebord 43 légèrement en saillie par rapport à la portion 39_{II} correspondante, de niveau II, de la semelle 22.

Au droit du passage 36, les éléments de paroi 30 séparant les compartiment 31, 32 sont affectés, jusqu'à leur base, par une fente 44, qui, comme la fente 35 précédemment décrite, fait communiquer entre eux ces compartiments 31, 32, mais qui, nettement plus large que cette fente 35, est destinée, elle, et suivant des modalités décrites ultérieurement, à être occultée en service.

Dans la forme de réalisation représentée, le passage 36 est en demi-lune, et, sur la face arrière de la semelle 22 du socle 10, il lui est associé une bride 46, qui, le complétant, est propre à permettre l'assujettissement, à la semelle 22, d'un tube souple 48 destiné à servir de logement aux conducteurs électriques 17.

Ce tube souple 48, qui, tel que représenté, sur un tronçon de sa longueur, à la figure 3, est, par exemple, un tube annelé, s'étend, donc, à compter du passage 36, et, disposé dans le dégagement 28 que forme sur sa face arrière la semelle 22, il traverse cette semelle 22 à la faveur d'un quelconque de ses ajours 38.

Enfin, dans les zones d'angle de la semelle 22, sur la face avant de celle-ci, des éléments de paroi supplémentaires 50 bordent, localement, sur son périmètre intérieur, le volume périphérique 33 présent sur cette face avant.

En pratique, ces éléments de paroi supplémentaires 50 présentent un pan coupé laissant à l'extérieur du volume périphérique 33 les puits 23.

Par contre, entre eux et les éléments de paroi 30, s'étendent les perçages 24A, 24B.

En pratique, les puits 23 font saillie sur une portion 39_{I} de niveau I de la semelle 22 tandis que les perçages 24A, 24B sont formés sur une portion 39_{II} de niveau II de celle-ci.

Au socle 10 ainsi constitué, il est associé des cavaliers 52, à raison d'un par ajour 37 de la réglette 34.

L'un d'eux est représenté isolément à la figure 8.

Destiné à être engagé dans un ajour 37 de la réglette 34, il comporte deux jambages 53, qui sont crantés extérieurement, pour coopération en retenue avec les bords transversaux obliques d'un tel ajour 37, et une platine 54, qui, transversalement, déborde, latéralement, et, de part et d'autre, des jambages 53, ce qui n'est pas visible sur la figure, et qui, sur sa surface supérieure, présente, longitudinalement, deux rainures 56 propres à l'encliquetage d'un quelconque repère non représenté.

Lors de sa pose sur le support à équiper, le socle 10 suivant l'invention n'est équipé que de la seule carte de base 13.

Cette carte de base 13 est rapportée sur le fond de son compartiment 31.

Comme déjà indiqué, elle porte, outre d'autres composants, des borniers 20.

En pratique, ces borniers 20 sont disposés en bordure de cette carte de base 13, du côté ouvert du compartiment 31.

Ils sont donc disposés en bordure de la réglette 34, et, donc, au-delà de celle-ci, en bordure du volume périphérique 33.

Par exemple, et tel que représenté, ils sont tous alignés les uns avec les autres.

Suivant l'implantation du socle 10 suivant l'invention par rapport à l'arrivée des conducteurs 17, le tube souple 48 destiné au logement de ces conducteurs 17 pénètre, latéralement, dans le dégagement 28 présent sur la face arrière de la semelle 22, sur l'un ou l'autre des côtés de celle-ci, à la faveur de l'ajour 38 correspondant de cette semelle 22.

Initialement, ces conducteurs 17, à leur débouché hors du tube souple 48, s'épanouissent librement, à la faveur du passage 36 et de la fente 44 des éléments de paroi 30 présents au droit de celui-ci, dans le compartiment 32 réservé à la batterie 14C, tel que schématisé en traits interrompus sur la figure 4.

Lors du câblage, ils sont raccordés à la borne de connexion 19 portée par la carte de base 13, les dispositions étant telles que cette borne de connexion 19 s'étende en bordure du logement 40, le long d'un des côtés transversaux de celui-ci, au voisinage immédiat du passage 36.

Après ce raccordement, et tel que schématisé en trait plein sur la figure 9, le mou de ces conducteurs 17 est absorbé dans le logement 40.

Comme les conducteurs 17, les conducteurs 18 peuvent arriver par n'importe quel côté de la semelle 22 du socle 10 suivant l'invention, soit, latéralement, comme schématisé en traits interrompus sur la figure 4, soit par en dessous.

Mais, à la différence des conducteurs 17, ils sont laissés à l'écart des compartiments 31, 32 présents sur la face avant de cette semelle 22, pour ne cheminer que dans le seul volume périphérique 33 extérieur à ceux-ci, soit que, arrivant latéralement, ils pénètrent directement dans ce volume périphérique 33, soit que, arrivant par en dessous, ils y pénètrent à la faveur d'un des ajours 38 de cette semelle 22.

Quoi qu'il en soit, ils sont raccordés, à leur extrémité, aux borniers 20.

Au passage, ils sont, chacun individuellement, engagés sous un cavalier 52, et celui-ci est encliqueté dans l'ajour 37 de la réglette 34 correspondant au bornier 20 concerné.

Les conducteurs 18 sont ainsi avantageusement maintenus, par coincement, en position.

Le câblage, ainsi fait, des conducteurs 18, peut intervenir avant ou après la mise en place des blocs fonctionnels 14A, 14B et de celle de la batterie 14C.

Une fois en place, le bloc fonctionnel 14A, qui est le bloc d'alimentation, et qui est amovible, recouvre, d'une part, le logement 40 par lequel débouche le passage 36, et, d'autre part, la borne de connexion 19 disposée en bordure de ce logement 40.

Il recouvre donc, totalement, les conducteurs 17, en complétant ainsi la séparation diélectrique, par rapport à eux, des conducteurs 18.

De préférence, et tel qu'il est visible à la figure 1, le boîtier de ce bloc fonctionnel 14A présente, en saillie sur sa face arrière, une patte 55, qui, prévue au droit du passage 36, vient occulter la fente 44 des éléments de parois 30 séparant l'un de l'autre les compartiments 31, 32, en isolant ainsi, dès cet instant, ces deux compartiments 31, 32 l'un de l'autre.

Le cheminement des conducteurs électriques nécessaires à la desserte de la batterie 14C par le bloc fonctionnel 14A se fait en effet à la faveur de la fente 35 prévue par ailleurs entre les éléments de paroi 30 correspondants.

Bien entendu, la présente invention ne se limite pas à la forme de réalisation décrite et représentée, mais englobe toute variante d'exécution dans les limites des revendications.

En outre, il peut être prévu un micro-rupteur propre à déclencher un avertisseur dans le cas d'un arrachement du couvercle 11 vis-à-vis du socle 10, et/ou d'un arrachement de ce socle 10 vis-à-vis du support sur lequel il est rapporté.

Enfin, bien que plus particulièrement destiné à une centrale d'alarme, le socle suivant l'invention peut éventuellement également convenir à d'autres appareillages électriques, et, par exemple, à un transmetteur téléphonique.

## Revendications

1. Socle pour appareillage électrique, notamment centrale d'alarme, du genre comportant une semelle (22) propre à son application contre un quelconque support et à sa fixation à celui-ci, caractérisé en ce que, à l'intérieur de son pourtour, ladite semelle (22) s'étend suivant au moins deux niveaux (I,II) différents, en sorte que, sur sa face arrière, elle forme un dégagement (28) destiné au cheminement de conducteurs (17) porteurs de courant d'une première nature, par exemple de conducteurs porteurs de courant fort, en ce que, sur sa face avant, elle porte, en retrait par rapport à son pourtour, sur une partie au moins de la longueur de ce pourtour, des éléments de paroi (30), qui, en saillie sur cette face avant, y délimitent au moins pour partie au moins un compartiment (31,32) destiné au logement de composants fonctionnels, avec au moins un passage (36) par lequel ledit dégagement (28) communique avec un tel compartiment (31,32), et en ce qu'elle présente, sur l'un au moins de ses côtés, entre lesdits éléments de paroi (30) et son pourtour, au moins un ajour (38) par lequel ledit dégagement (28) communique par ailleurs avec un volume périphérique (33), qui, extérieur audit compartiment (31,32), est destiné au cheminement de conducteurs (18) porteurs de courant d'une deuxième nature, par exemple de conducteurs porteurs de courant faible.

2. Socle suivant la revendication 1, caractérisé en ce qu'un ajour (38) de sa semelle (22) est bordé pour partie par une portion (39_{I}) de premier niveau (I) de celle-ci et pour partie par une portion (39_{II}) de deuxième niveau (II), en sorte que c'est à la faveur du décalage entre ces portions (39_{I}, 39_{II}) de niveaux (I, II) différents qu'il fait communiquer le dégagement (28) présent sur la face arrière de cette semelle (22) avec le volume périphérique (33) présent sur sa face avant.

3. Socle suivant l'une quelconque des revendications 1, 2, caractérisé en ce que sa semelle (22) présente un ajour (38) sur chacun de ses côtés.

4. Socle suivant l'une quelconque des revendications 1 à 3, caractérisé en ce que la semelle (22) s'étend principalement, d'une part, suivant un premier niveau (I), qui correspond à celui de sa face arrière, et, d'autre part, suivant un deuxième niveau (II), qui, en retrait par rapport au précédent, est également en retrait par rapport à son pourtour.

5. Socle suivant la revendication 4, caractérisé en ce que, à l'intérieur d'un compartiment (31, 32) délimité par les éléments de paroi (30), sur une partie au moins de ce compartiment (31, 32), la semelle (22) s'étend suivant un autre niveau (III, IV), intermédiaire entre les deux premiers.

6. Socle suivant l'une quelconque des revendications 1 à 4, caractérisé en ce que, dans le dégagement (28) que forme sa semelle (22) sur sa face arrière, est disposé un tube souple (48), qui s'étend à compter du passage (36) faisant communiquer ce dégagement (28) avec un compartiment (31, 32) présent sur sa face avant, et traverse cette semelle (22) à la faveur d'un de ses ajours (38).

7. Socle suivant l'une quelconque des revendications 1 à 6, caractérisé en ce que le passage (36) faisant communiquer le dégagement (28) présent sur la face arrière de sa semelle (22) avec un compartiment (31, 32) présent sur sa face avant débouche dans un logement (40) qui est en creux par rapport audit compartiment (31, 32).

8. Socle suivant l'une quelconque des revendications 1 à 7, caractérisé en ce que le passage (36) faisant communiquer le dégagement (28) présent sur la face arrière de sa semelle (22) avec un compartiment (31, 32) présent sur sa face avant est formé à la faveur d'une paroi de raccordement (42) intermédiaire entre deux portions (39_{II}, 39_{IV}) de niveaux (II, IV) différents de cette semelle (22).

9. Socle suivant les revendications 6 et 8, prises conjointement, caractérisé en ce que ledit passage (36) est en demi-lune, et il lui est associé une bride (46), qui, le complétant, est propre à permettre l'assujettissement, à la semelle (22), du tube souple (48) présent dans le dégagement (28) qu'elle forme sur sa face arrière.

10. Socle suivant l'une quelconque des revendications 1 à 9, caractérisé en ce que sont présents sur la face avant de sa semelle (22) deux compartiments (31, 32), l'un que cernent des éléments de paroi (30) sur la quasi totalité de son pourtour, l'autre qui, en bordure du volume périphérique (33) extérieur à l'ensemble, est au moins en partie ouvert sur l'un au moins de ses côtés.

11. Socle suivant la revendication 10, caractérisé en ce que celui des compartiments (31, 32) présents sur la face avant de sa semelle (22), qui, par le passage (36) prévu à cet effet, communique avec le dégagement (28) présent sur sa face arrière est le compartiment (31) ouvert sur l'un de ses côtés.

12. Socle suivant l'une quelconque des revendications 10, 11, caractérisé en ce que les deux compartiments (31, 32) présents sur la face avant de sa semelle (22) communiquent entre eux.

13. Socle suivant l'une quelconque des revendications 1 à 12, caractérisé en ce que, dans les zones d'angle de sa semelle (22), des éléments de paroi supplémentaires (50) bordent localement, sur son périmètre extérieur, le volume périphérique (33) présent sur la face avant de cette semelle (22).

14. Socle suivant l'une quelconque des revendications 1 à 13, caractérisé en ce que l'un des compartiments (31, 32) présents sur la face avant de sa semelle (22) est bordé, le long de l'un au moins de ses côtés, par une réglette (34) présentant, de place en place, des ajours (37).

15. Socle suivant la revendication 14, caractérisé en ce qu'il lui est associé au moins un cavalier (52) propre à être engagé dans un ajour (37) de la réglette (34).

16. Socle suivant les revendications 10, 14, prises conjointement, caractérisé en ce que celui des compartiments (31, 32) présents sur la face avant de sa semelle (22) qui est bordé le long de l'un au moins de ses côtés par une réglette (34) est le compartiment (31) ouvert sur l'un de ses côtés, et ladite réglette (34) s'étend le long du côté ouvert dudit compartiment (31).

17. Appareillage électrique, en particulier centrale d'alarme, du genre comportant, rapportés sur un socle (10), une pluralité de blocs fonctionnels (14A,14B), caractérisé en ce que ledit socle (10) est conforme à l'une quelconque des revendications 1 à 16.

18. Appareillage électrique suivant la revendication 17, caractérisé en ce que, des borniers (20) étant prévus, ces borniers (20) sont disposés en bordure du volume périphérique (33) présent sur la face avant de la semelle (22) du socle (10).

19. Appareillage électrique suivant l'une quelconque des revendications 17, 18, caractérisé en ce que, le socle (10) étant conforme à la revendication 7, l'un des blocs fonctionnels (14A, 14B), qui est amovible, recouvre, d'une part, le logement (40) dans lequel débouche le passage (36) faisant communiquer le dégagement (28) présent sur la face arrière de la semelle (22) de ce socle (10) avec un compartiment (31, 32) présent sur sa face avant, et, d'autre part, une borne de connexion (19) disposée en bordure de ce logement (40).

20. Appareillage électrique suivant la revendication 19, caractérisé en ce que le boîtier dudit bloc fonctionnel (14A, 14B) présente en saillie sur sa face arrière, une patte (55), qui, au droit dudit passage (36), occulte une fente (44) faisant communiquer entre eux les compartiments (31, 32) présents sur la face avant de la semelle (22).

## Patentansprüche

1. Sockel für elektrisches Gerät, insbesondere Alarmeinrichtung, mit einer Bodenplatte (22) für seine Anlage an einem beliebigen Träger und seine Befestigung an diesem, dadurch gekennzeichnet, daß die Bodenplatte (22) sich im Inneren ihres Umfangs in wenigstens zwei verschiedenen Niveaus (I, II) erstreckt, so daß sie auf ihrer Rückseite eine Ausnehmung (28) formt, die zur Verlegung von Strom einer ersten Art führenden Leitern (17), beispielsweise starkstromführenden Leitern, bestimmt ist, daß sie auf ihrer Vorderseite bezüglich ihres Umfangs zurückversetzt auf wenigstens einem Teil der Länge dieses Umfangs Wandelemente (30) trägt, die auf dieser Vorderseite vorstehend auf dieser wenigstens zum Teil wenigstens ein Abteil (31, 32) abgrenzen, das zur Aufnahme von Funktionsbauelementen bestimmt ist, und wenigstens einen Durchgang (36) besitzen, über den die Ausnehmung (28) mit einem solchen Abteil (31, 32) in Verbindung ist, und daß sie wenigstens auf einer ihrer Seiten zwischen den Wandelementen (30) und ihrem Umfang wenigstens eine Öffnung (38) besitzt, über die die Ausnehmung (28) außerdem mit einem Umfangsvolumen (33) in Verbindung ist, das sich außerhalb des Abteils (31, 32) befindet und zur Verlegung von Strom einer zweiten Art führenden Leitern (18), beispielsweise schwachstromführenden Leitern, bestimmt ist.

2. Sockel nach Anspruch 1, dadurch gekennzeichnet, daß eine Öffnung (38) seiner Bodenplatte (22) zum Teil von einem Abschnitt (39_{I}) vom ersten Niveau (I) dieser Bodenplatte und zum Teil von einem Abschnitt (39_{II}) vom zweiten Niveau (II) gesäumt ist, so daß sie aufgrund der Versetzung zwischen diesen Abschnitten (39_{I}, 39_{II}) mit verschiedenen Niveaus (I, II) die auf der Rückseite der Bodenplatte (22) vorhandene Ausnehmung (28) mit dem auf ihrer Vorderseite vorhandenen Umfangsvolumen (33) verbindet.

3. Sockel nach einem der Ansprüche 1, 2, dadurch gekennzeichnet, daß seine Bodenplatte (22) auf jeder ihrer Seiten eine Öffnung (38) aufweist.

4. Sockel nach einem der Ansprüche 1 bis 3, dadurch gekennzeichnet, daß die Bodenplatte (22) sich hauptsächlich einerseits in einem ersten Niveau (I), das dem ihrer Rückseite entspricht, und andererseits in einem zweiten Niveau (II) erstreckt, das bezüglich des vorhergehenden sowie auch bezüglich ihres Umfangs zurückversetzt ist.

5. Sockel nach Anspruch 4, dadurch gekennzeichnet, daß sich die Bodenplatte (22) im Inneren eines Abteils (31, 32), das durch die Wandelemente (30) abgegrenzt ist, auf wenigstens einem Teil dieses Abteils (31, 32) in einem anderen Niveau (III, IV) erstreckt, das zwischen den beiden ersten liegt.

6. Sockel nach einem der Ansprüche 1 bis 4, dadurch gekennzeichnet, daß in der Ausnehmung (28), die seine Bodenplatte (22) auf ihrer Rückseite bildet, ein Schlauch (48) angeordnet ist, der sich von dem Durchgang (36) aus erstreckt, der diese Ausnehmung (28) mit einem auf ihrer Vorderseite vorhandenen Abteil (31, 32) verbindet, und diese Bodenplatte (22) über eine ihrer Öffnungen (38) durchquert.

7. Sockel nach einem der Ansprüche 1 bis 6, dadurch gekennzeichnet, daß der Durchgang (36), der die auf der Rückseite seiner Bodenplatte (22) vorhandene Ausnehmung (28) mit einem auf ihrer Vorderseite vorhandenen Abteil (31, 32) verbindet, in eine Aufnahme (40) mündet, die bezüglich diesem Abteil (31, 32) vertieft ist.

8. Sockel nach einem der Ansprüche 1 bis 7, dadurch gekennzeichnet, daß der Durchgang (36), der die auf der Rückseite seiner Bodenplatte (22) vorhandene Ausnehmung (28) mit einem auf ihrer Vorderseite vorhandenen Abteil (31, 32) verbindet, mittels einer Zwischenverbindungswand (42) zwischen zwei Abschnitten (39_{II}, 39,_{IV}) mit verschiedenen Niveaus (II, IV) dieser Bodenplatte (22) geformt ist.

9. Sockel nach den Ansprüchen 6 und 8 zusammen, dadurch gekennzeichnet, daß der Durchgang (36) halbmondförmig ist und daß ihm ein Bügel (46) zugeordnet ist, der ihn ergänzt und die Anbringung des Schlauchs (48), der in der Ausnehmung (28), die sie auf ihrer Rückseite formt, vorgesehen ist, an der Bodenplatte (22) gestattet.

10. Sockel nach einem der Ansprüche 1 bis 9, dadurch gekennzeichnet, daß auf der Vorderseite seiner Bodenplatte (22) zwei Abteile (31, 32) vorhanden sind, deren eines die Wandelemente (30) fast auf seinem gesamten Umfang abgrenzen und deren anderes an dem außerhalb des Ganzen gelegenen Umfangsvolumen (33) entlang wenigstens zum Teil auf wenigstens einer seiner Seiten offen ist.

11. Sockel nach Anspruch 10, dadurch gekennzeichnet, daß dasjenige der auf der Vorderseite seiner Bodenplatte (22) vorhandenen Abteile (31, 32), das über den hierzu vorgesehenen Durchgang (36) mit der auf ihrer Rückseite vorhandenen Ausnehmung (28) verbunden ist, das auf einer seiner Seiten offene Abteil (31) ist.

12. Sockel nach einem der Ansprüche 10, 11, dadurch gekennzeichnet, daß die beiden auf der Vorderseite seiner Bodenplatte (22) vorhandenen Abteile (31, 32) miteinander verbunden sind.

13. Sockel nach einem der Ansprüche 1 bis 12, dadurch gekennzeichnet, daß in den Eckzonen seiner Bodenplatte (22) zusätzliche Wandelemente (50) örtlich auf seinem Außenumfang das auf der Vorderseite dieser Bodenplatte (22) vorhandene Umfangsvolumen (33) säumen.

14. Sockel nach einem der Ansprüche 1 bis 13, dadurch gekennzeichnet, daß eines der auf der Vorderseite seiner Bodenplatte (22) vorhandenen Abteile (31, 32) längs wenigstens einer seiner Seiten durch eine Leiste (34) gesäumt ist, die von Stelle zu Stelle Öffnungen (37) aufweist.

15. Sockel nach Anspruch 14, dadurch gekennzeichnet, daß ihm wenigstens ein Reiter (52) zugeordnet ist, der in eine Öffnung (37) der Leiste (34) eingesteckt werden kann.

16. Sockel nach den Ansprüchen 10, 14 zusammen, dadurch gekennzeichnet, daß dasjenige der auf der Vorderseite seiner Bodenplatte (22) vorhandenen Abteile (31, 32), das längs wenigstens einer seiner Seiten von einer Leiste (34) gesäumt ist, das auf einer seiner Seiten offene Abteil (31) ist und die Leiste (34) sich längs der offenen Seite dieses Abteils (31) erstreckt.

17. Elektrisches Gerät, insbesondere Alarmeinrichtung, umfassend eine Vielzahl von auf einem Sockel (10) angebrachten Funktionsblöcken (14A, 14B), dadurch gekennzeichnet, daß der Sockel (10) gemäß einem der Ansprüche 1 bis 16 ausgebildet ist.

18. Elektrisches Gerät nach Anspruch 17, dadurch gekennzeichnet, daß, indem Klemmenleisten (20) vorgesehen sind, diese Klemmenleisten (20) am Rand des auf der Vorderseite der Bodenplatte (22) des Sockels (10) vorgesehenen Umfangsvolumens (33) angeordnet sind.

19. Elektrisches Gerät nach einem der Ansprüche 17, 18, dadurch gekennzeichnet, daß, indem der Sockel (10) gemäß Anspruch 7 ausgebildet ist, einer der Funktionsblöcke (14A, 14B), der abnehmbar ist, einerseits die Aufnahme (40) abdeckt, in die der Durchgang (36) mündet, der die auf der Rückseite der Bodenplatte (22) dieses Sockels (10) vorhandene Ausnehmung (28) mit einem auf ihrer Vorderseite vorhandenen Abteil (31, 32) verbindet, und andererseits eine Anschlußklemme (19), die am Rand dieser Aufnahme (40) angeordnet ist.

20. Elektrisches Gerät nach Anspruch 19, dadurch gekennzeichnet, daß das Gehäuse dieses Funktionsblocks (14A, 14B) auf seiner Rückseite hervorstehend einen Lappen (55) aufweist, der in Höhe dieses Durchgangs (36) einen Schlitz (44) abdeckt, der die auf der Vorderseite der Bodenplatte (22) vorhandenen Abteile (31, 32) miteinander verbindet.

## Claims

1. A base for electrical equipment, in particular an alarm station, of the type comprising a base plate (22) for applying it against any support and for fixing it to the support, characterised in that within its periphery the base plate (22) extends at at least two different levels (I, II) so that, on its rear face, it forms a recess portion (28) intended for the passage of conductors (17) for carrying current of a first nature, for example conductors for carrying heavy current, that on its front face, and set back with respect to its periphery, over a part at least of the length of said periphery it carries wall elements (30) which, projecting from said front face, delimit thereat at least in respect of part thereof at least one compartment (31, 32) intended to accumulate functional components, with at least one passage (36) by way of which said recess portion (28) communicates with such a compartment (31, 32), and that, on one at least of its sides and between said wall elements (30) and its periphery, it has at least one opening (38) by way of which said recess portion (28) also communicates with a peripheral volume (33) which, being external to said compartment (31, 32), is intended for the passage of conductors (18) for carrying current of a second nature, for example conductors for carrying a light current.

2. A base according to claim 1 characterised in that an opening (38) of the base plate (22) thereof is bounded in respect of part thereof by a portion (39_{I}) of the first level (I) thereof and in respect of part by a portion (39_{II} ) of the second level (II), such that it is by virtue of the displacement between said portions (39_{I} , 39_{II}) of different levels (I, II) that it communicates the recess portion (28) provided at the rear face of said base plate (22) with the peripheral volume (33) at its front face.

3. A base according to either one of claims 1 and 2 characterised in that its base plate (22) has an opening (38) on each of its sides.

4. A base according to any one of claims 1 to 3 characterised in that the base plate (22) extends primarily on the one hand at a first level (I) which corresponds to that of its rear face and on the other hand at a second level (II) which, set back with respect to the foregoing level, is also set back with respect to its periphery.

5. A base according to claim 4 characterised in that, within a compartment (31, 32) which is delimited by the wall elements (30), over a part at least of said compartment (31, 32), the base plate (22) extends at another level (III, IV) which is intermediate between the first two levels.

6. A base according to any one of claims 1 to 4 characterised in that disposed in the recess portion (28) which is formed by its base plate (22) on its rear face is a flexible tube (48) which extends from the passage (36) communicating said recess portion (28) with a compartment (31, 32) provided at its front face and passes through said base plate (22) by way of one of its openings (38).

7. A base according to any one of claims 1 to 6 characterised in that the passage (36) communicating the recess portion (28) at the rear face of its base plate (22) with a compartment (31, 32) at its front face opens into a housing (40) which is recessed with respect to said compartment (31, 32).

8. A base according to any one of claims 1 to 7 characterised in that the passage (36) communicating the recess portion (28) at the rear face of its base plate (22) with a compartment (31, 32) at its front face is formed by means of a connecting wall (42) which is intermediate between two portions (39_{II}, 39_{IV}) at different levels (11, IV) of said base plate (22).

9. A base according to claims 6 and 8 in combination characterised in that said passage (36) is of a half-moon shape and associated therewith is a clamp (46) which, completing same, is such as to permit fixing to the base plate (22) of the flexible tube (48) disposed in the recess portion (28) that the base plate forms on its rear face.

10. A base according to any one of claims 1 to 9 characterised in that provided on the front face of its base plate (22) are two compartments (31, 32), one which is enclosed by wall elements (30) over virtually the whole of its periphery, and the other which, bounding the peripheral volume (33) external to the assembly, is at least in part open on one at least of its sides.

11. A base according to claim 10 characterised in that that one of the compartments (31, 32) on the front face of its base plate (22) which, by way of the passage (36) provided for that purpose, communicates with the recess portion (28) at its rear face, is the compartment (31) which is open at one of its sides.

12. A base according to either one of claims 10 and 11 characterised in that the two compartments (31, 32) at the front face of its base plate (22) communicate with each other.

13. A base according to any one of claims 1 to 12 characterised in that, in the comer zones of its base plate (22), supplementary wall elements (50) locally bound over its external perimeter the peripheral volume (33) at the front face of said base plate (22).

14. A base according to any one of claims 1 to 13 characterised in that one of the compartments (31, 32) at the front face of its base plate (22) is bounded along one at least of its sides by a guide strip (34) having openings (37) at spacings therealong.

15. A base according to claim 14 characterised in that associated therewith is at least one slider (52) capable of being engaged into an opening (37) in the guide strip (34).

16. A base according to claims 10 and 14 in combination characterised in that that one of the compartments (31, 32) at the front face of its base plate (22) which is bounded along one at least of its sides by a guide strip (34) is the compartment (31) which is open on one of its sides and said guide strip (34) extends along the open side of said compartment (31).

17. Electrical equipment, in particular an alarm station, of the type comprising, fitted to a base (10), a plurality of functional blocks (14A, 14B), characterised in that said base (10) is in accordance with any one of claims 1 to 16.

18. Electrical equipment according to claim 17 characterised in that, terminal members (20) being provided, said terminal members (20) are disposed along the side of the peripheral volume (33) at the front face of the base plate (22) of the base (10).

19. Electrical equipment according to either one of claims 17 and 18 characterised in that, the base (10) being in accordance with claim 7, one of the functional blocks (14A, 14B) which is removable covers on the one hand the housing (40) into which opens the passage (46) communicating the recess portion (28) at the rear face of the base plate (22) of said base (10) with a compartment (31, 32) at its front face and on the other hand a connecting terminal (19) disposed at the edge of said housing (40).

20. Electrical equipment according to claim 19 characterised in that the casing of said functional block (14A, 14B), in projecting relationship on its rear face, has a lug (55) which, in line with said passage (36), hides a slot (44) communicating the compartments (31, 32) at the front face of the base plate (22) with each other.
